Europäisches Patentamt

European Patent Office

Office européen des brevets

(11) Publication number: **0 237 078 B1**

# EUROPEAN PATENT SPECIFICATION

(45) Date of publication of patent specification: **30.12.92**

(51) Int. Cl.⁵: **H01J  37/32**, H05H 1/46,
C23F 4/00

(21) Application number: **87103642.2**

(22) Date of filing: **13.03.87**

(54) **Downstream microwave plasma processing apparatus having an improved coupling structure between microwave and plasma.**

(30) Priority: **13.03.86 JP 55447/86**

(43) Date of publication of application:
**16.09.87 Bulletin  87/38**

(45) Publication of the grant of the patent:
**30.12.92 Bulletin  92/53**

(84) Designated Contracting States:
**DE FR GB**

(56) References cited:
**EP-A- 0 183 561**
**US-A- 4 512 868**

**PATENT ABSTRACTS OF JAPAN, vol. 9, no. 143 (E-322)[1866], 18th June 1985 & JP-A-60 25 234 (FUJITSU K.K.) 08-02-1985**

(73) Proprietor: **FUJITSU LIMITED**
**1015, Kamikodanaka Nakahara-ku**
**Kawasaki-shi Kanagawa 211(JP)**

(72) Inventor: **Fujimura, Shuzo c/o FUJITSU LIMIT-ED Patent Dept.**
**Kosugi Fujitsu Building 1812-10**
**Shimonumabe**
**Nakahara-ku Kawasaki-shi Kanagawa 211(JP)**
Inventor: **Mihara, Satoru c/o FUJITSU LIMITED Patent Dept.**
**Kosugi Fujitsu Building 1812-10**
**Shimonumabe**
**Nakahara-ku Kawasaki-shi Kanagawa 211(JP)**
Inventor: **Kisa, Toshimasa c/o FUJITSU LIMIT-ED Patent Dept.**
**Kosugi Fujitsu Building 1812-10**
**Shimonumabe**
**Nakahara-ku Kawasaki-shi Kanagawa 211(JP)**
Inventor: **Motoki, Yasumari c/o FUJITSU LIMIT-ED Patent Dept.**
**Kosugi Fujitsu Building 1812-10**
**Shimonumabe**
**Nakahara-ku Kawasaki-shi Kanagawa 211(JP)**

(74) Representative: **Greenstreet, Cyril Henry et al**
**Haseltine Lake & Co. Hazlitt House 28 South-ampton Buildings Chancery Lane**
**London WC2A 1AT(GB)**

## Description

The present invention relates to a downstream plasma processing apparatus used for an etching or ashing process during fabrication of an integrated circuit semiconductor (IC) or similar devices. More particularly, the present invention relates to a downstream plasma microwave etching apparatus having an improved coupling structure between a wave guide and a plasma generation region for providing fairly uniform etching or ashing of an IC substrate or similar devices to be treated and stable matching of the relevant microwave circuit. The present invention enables uniform and fast downstream plasma processing of a semiconductor material by reducing the reflection of microwaves.

In a process for forming fine patterns in an IC device an etching process and an 'ashing' process have been employed, the etching process comprising etching off the protective layers of silicon, silicon dioxide, or silicon nitride formed on a semiconductor substrate, and the 'ashing' process comprising stripping or 'ashing' off a photoresist mask, consisting of an organic layer on the substrate. Recently 'wet' etching utilizing chemical solvents has been replaced by 'dry' etching, which has various advantages such as capability of fine resolution and less undercutting of the etched pattern, elimination of wafer handling for rinsing and drying, inherent cleanness, and the like. In particular, by employing plasma etching sequential etching and ashing operations on the same machine become possible, providing a possibility of a fully automated fabricating process for an IC device.

A plasma is a highly ionized gas containing nearly equal numbers of positive and negative charged particles, together with free radicals. The free radicals are electrically neutral atoms or molecules that can actively form chemical bonds with other atoms with which they come into contact. The free radicals generated in a plasma, acting as a reactive species, chemically combine with materials to be etched to form volatile compounds which are removed from the system by evacuation. Such plasma etching is referred to as reactive ion etching (RIE). Hence a plasma etching apparatus comprises essentially a plasma generation region, a reaction zone and an evacuating device.

In a plasma etching apparatus, a plasma is generated in a gas having a pressure of approximately 0.067 to $2.66 \times 10^2$ Pa (0.05 to 2 Torr) by applying radio-frequency or microwave energy to the gas. The efficiency of generation of the plasma, or of chemical radicals contained in the plasma, is thus an important factor in plasma processing. From this point of view microwave plasma etching or ashing has important advantages such as high plasma density and electrodeless discharge, and is widely used for the fabrication of IC devices.

There are two types of plasma processing. One is so-called 'oven type' plasma processing wherein an object to be worked is placed in a plasma generation region, where it is exposed to a plasma. The other is a 'downstream' plasma processing wherein an object to be treated is placed outside the plasma generation region. Since an IC device exposed in a plasma environment is generally damaged by ion bombardment, ultraviolet radiation, soft X-rays, and the like, the IC substrate should be shielded from the plasma. Downstream plasma processing is therefore preferably used for processing an IC substrate. Hereinafter, throughout this specification, the term 'plasma processing' means only the downstream plasma processing mentioned above.

Radicals generated in a plasma are introduced into a reaction zone to react with a material to be treated placed therein. Unfortunately the radicals tend to collide with other gas molecules or with wall surfaces, thereby being recombined and losing their chemical activity. It is therefore very important to reduce the recombination of the radicals. Taking these factors into consideration, an improved microwave plasma etching apparatus has been developed and proposed in U.S. Patent No. 4 512 868, issued on April 23, 1985 to S. Fujimura et al.

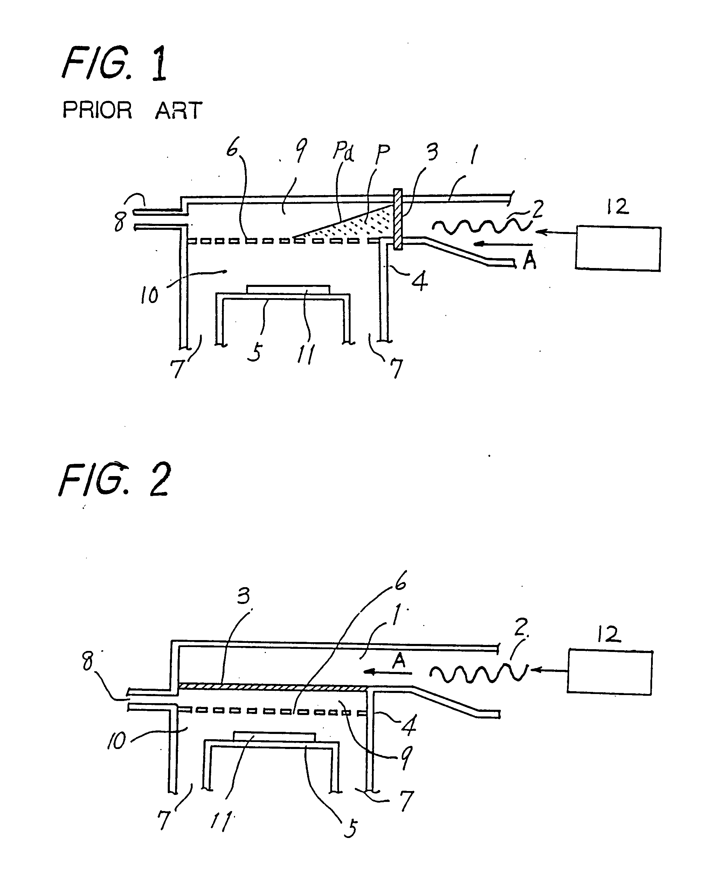

In the accompanying drawings Fig. 1 is a schematic cross-sectional view of a microwave plasma etching apparatus disclosed by the above U.S. patent. In this apparatus microwave power 2 supplied from a microwave power source 12 is transmitted through a wave guide 1 in the direction indicated by the arrow A. An evacuateable processing vessel 4, separated from the wave guide 1 by a window 3 of dielectric such as ceramic or silica glass, contains a plasma generation chamber 9 and a reaction chamber 10. The plasma generation chamber 9 is substantially part of the wave guide 1. The reaction chamber 10 spatially adjoins the plasma generation chamber 9 through a metallic mesh 6 which defines a portion of the wall of the wave guide 1. The metallic mesh 6 also acts as a microwave shielding member to prevent plasma generated in the chamber 9 from intruding into the reaction chamber 10, and thus to protect an object 11 on a stage 5 which is placed in the reaction chamber 10. At the same time, the metallic mesh 6 allows transmission of the radicals which are generated in the plasma.

The steps of the plasma processing are as follows: the processing vessel 4, including the plasma generation chamber 9 and the reaction chamber 10, is evacuated by a pumping device (not shown) through exhaust tubes 7. A reactive gas is introduced into the plasma generation chamber 9 through a gas inlet tube 8 and ionized by the microwave 2 to form a plasma P. Radicals generated in the plasma pass through the metallic mesh 6 to reach the object 11, such as a semiconductor substrate, mounted on the stage 5, and react with the object 11 forming volatile compounds which are exhausted by the pumping device. The plasma processing is thus carried out in the reaction chamber 10, i.e. downstream of the plasma, so that the plasma processing is a downstream plasma processing. The distance between the plasma generation chamber 9 and the object 11 may for example be made as small as approximately 0.8 cm. This short distance enables radicals to survive during their transmission to reach and effectively treat the object 11, providing a fairly high plasma processing rate.

As can be seen from Fig. 1, the dielectric window 3 is disposed in a direction perpendicular to the direction A of transmission of the microwave 2. In other words, the window 3 is disposed parallel to the electric field of the microwave 2. In this configuration, the microwave 2 is partially reflected by two sharp transitions of dielectric constants in the direction A of propagation of the microwave 2. One transition occurs at the interface between the air space and the dielectric window 3, and the other at the interface between the dielectric window 3 and a vacuum space or a space filled with a plasma in the plasma generation chamber 9, depending on the processing stage. In addition, the electrical impedance in the plasma generation chamber 9 also varies substantially, depending on the absence or presence of the plasma, causing serious difficulty in matching the relevant microwave circuit both when the plasma is triggered and when the plasma is maintained. In other words, if matching is previously attained while the plasma generation chamber 9 is kept under vacuum, such matching cannot be maintained during and after the generation of the plasma in the chamber 9, because the reflection of the microwave 2 is substantially increased upon the generation of the plasma. In practice, reflection of the microwave was 70% without matching and 30% with matching, using oxygen as reactive gas at a pressure of 1.33 $\times$ $10^2$ Pa (1 Torr). The mismatching of the microwave may result in unsatisfactory production of the plasma, and the sudden and large reflection of the microwave may damage the apparatus.

Another problem is decay of the microwave in the plasma generation chamber 9. The electrical energy of the microwave 2 is consumed in ionizing reactive plasma gas molecules as it enters the plasma generation chamber 9, and decays rapidly. Consequently the intensity of the electric field of the microwave 2 drops rapidly as the microwave 2 is propagated in the direction A in the plasma generation chamber 9. As a result, the distribution of plasma density P falls rapidly as shown by the line Pd in Fig. 1.

When long life radicals such as fluoride radicals generated from carbon tetrafluoride ($CF_4$) gas are utilized, the radicals can reach the object 11 approximately uniformly, because the radicals can survive until they reach the object after repeated collisions with other particles and vessel walls, each time changing their direction. However, in the case of short-life radicals such as oxygen radicals which are utilized for ashing a photoresist layer, the radicals which succeed in reaching the object are almost limited to the ones originally directed towards the object when they are generated. Thus the distribution of the plasma processing rate of the object 11 is similar to that of the generation of the radicals in the plasma, causing difficulty in achieving uniform plasma processing of an object having an extended area such as a photoresist layer coated on a large silicon wafer.

Several methods have been proposed for dealing with the problem just described. For example, in an ashing process for removing a photoresist layer over a semiconductor substrate 11, a pressure difference is produced between the pressure of the reactive gas, namely oxygen gas, in the plasma generation chamber 9 and that in the reaction chamber 10, in order to provide uniform generation of radicals in the plasma generation chamber 9. However, the increase in the oxygen gas pressure in the plasma generation chamber 9 leads to more frequent collisions between the oxygen radicals and the oxygen gas molecules, thus reducing the active life of the radicals and resulting in practice in an unsatisfactory ashing rate. Another counter measure consists in adding carbon tetrafluoride gas ($CF_4$) to oxygen ($O_2$) gas to extend the active life of the oxygen radicals. In this method, however, fluoride radicals are also generated, damaging the circuits and layers on the substrate.

Apart from the downstream plasma processing, in an 'oven type' plasma processing apparatus, which as already mentioned cannot be used for the dry etching or ashing treatment of a semiconductor substrate, a similar problem occurs, caused by the rapid decay of the relevant microwave during its propagation in a plasma. In order to overcome the problem, an improved configuration of the associated wave guide has been proposed by S. Fujimura et al. in EP-A-0 183 561, published on 4th June, 1986. In that patent application, Fujimura proposed a new wave guide configuration having a microwave transmission window made of dielectric material disposed perpendicular to an electric field of progressive microwaves in the wave guide. With this configuration, the mode of the microwave transmission from the wave guide to a reaction chamber (a reactor) is not adversely affected, and the microwave is effectively absorbed in the plasma. However, the apparatus disclosed in the specification is an 'oven type' plasma processing apparatus, and is essentially different from a downstream plasma processing apparatus wherein an object to be treated is placed outside the plasma and treated by radicals. In order to overcome the problems described above of non-uniform and unstable plasma processing, there is a need for a further improved downstream plasma processing apparatus for semiconductor fabrication.

An embodiment of the present invention can provide an improved microwave plasma processing apparatus for fabricating integrated circuit semiconductor devices and similar devices.

An embodiment of the present invention can also provide a downstream microwave plasma processing apparatus having improved coupling of microwave to plasma, thereby providing stable matching of the relevant microwave circuit, and uniform plasma etching or ashing of an object being treated.

In a downstream plasma processing apparatus according to the present invention, a microwave transmitting window is disposed in a wave guide approximately parallel to the direction of transmission of the microwave, and a vacuum-tight processing vessel is attached to the microwave transmitting window made of dielectric material, which forms part of the vessel. The processing vessel is thus disposed adjacent to the wave guide. The processing vessel contains a plasma generation chamber and a reaction chamber which are separated electrically from each other and spatially adjoining to each other by a perforated shield member, e.g. a metallic mesh or a perforated metal foil such as a shower head plate. The plasma generation chamber is thus defined by the microwave transmitting window and the shielding member. The electric field of the microwave, formed almost perpendicularly to the microwave transmitting window, is transmitted through the microwave transmitting window into the plasma generation chamber and confined therein by the shielding member. After evacuation of the processing vessel a reactive gas is fed into the plasma generation chamber and a plasma is generated by ionizing the gas by means of the microwave. Radicals generated in the plasma pass through the shield member, impinge directly on to the surface of an object such as a semiconductor substrate placed in the reacting chamber, and react with the material on the surface In other words, the object is subjected to downstream plasma processing. In this the free path of the radicals is very short, so that radicals having a short life, such as oxygen radicals, can be used as reactive species.

An apparatus according to the invention thus comprises:

a microwave power source;

a wave guide for transmitting microwaves generated in said microwave power source;

a microwave transmitting window disposed in a wall of said wave guide, disposed perpendicular to an electric field of said microwaves in said wave guide;

a vacuum processing vessel, a portion of which is defined by said microwave transmitting window;

a shielding member having a plurality of openings, separating the inside space of said processing vessel into a plasma generation chamber and a reaction chamber, said plasma generation chamber being defined by said microwave transmitting window and said shielding member; and

a stage disposed in said reaction chamber facing said shielding means, for mounting said substrate.

With the configuration of the plasma processing apparatus described above, the input microwave is propagated along the microwave transmitting window without substantial decay because a major portion of the wave guide, up to its end, is air space, providing a fairly uniform characteristic impedance. Thus, reflection and losses of the microwave caused in the direction of propagation of the microwave are kept quite small, resulting in a fairly uniform distribution of the density of the plasma across the width of the plasma generation chamber. As a result the distribution of radicals impinging on the surface of the object or the substrate is uniform, so that a large object can be effectively and uniformly plasma treated utilizing a short-life reacting gas. In addition, the fine patterns formed on the surface of the object, an IC substrate, are protected from damage caused by the plasma.

Furthermore the change in the load impedance of the wave guide is fairly small irrespective of the presence or absence of a plasma in the plasma generation chamber. Accordingly, matching of the relevant microwave electric circuit including the wave guide becomes easier compared with the prior art. In particular the initiation or ignition of the plasma becomes very easy and stable.

An embodiment of the present invention will now be described in more detail with reference to the accompanying drawings, in which like reference numerals designate like parts and wherein:

Fig. 1 is a cross-sectional side view of a prior art microwave plasma processing apparatus having a wave guide electrically coupled to a plasma generation chamber which is disposed adjacent to a reaction chamber; and

Fig. 2 is a diagrammatic cross-sectional side view of a microwave plasma processing apparatus according to the present invention.

The prior art apparatus of Fig. 1 has already been discussed above.

Referring to Fig. 2, a microwave 2 generated by a microwave power source 12 having a predetermined frequency is transmitted along a wave guide 1 in a direction indicated by the arrow A. A microwave transmitting window 3, made of silica or ceramic, is disposed perpendicular to the electric field of the microwave 2. That is to say, the main plane of the microwave transmitting window 3 is disposed parallel to the direction A. In this respect the plasma processing apparatus according to the present invention is clearly distinguished from the apparatus of Fig. 1. The plasma processing apparatus according to the present invention, is also clearly distinguished from that of EP-A-0 183 561 in that the latter is an 'oven type' apparatus, as opposed to the downstream apparatus of the present invention.

In structural respects other than the microwave transmitting window the apparatus of the present invention is essentially the same as that of Fig. 1. A processing vessel 4 is attached to the wave guide 1, being partitioned from the wave guide 1 by the microwave transmitting window 3. A plasma generation chamber 9 and a reaction chamber 10 are formed in the processing vessel 4 by means of a metallic mesh 6 which electrically separates the two spatially adjoining chambers. The metallic mesh 6 can be replaced by a metallic shower head or the like which has a number of holes to allow the passage of the radicals and shields the microwave within the plasma generation chamber 9. The plasma generation chamber 9 is thus substantially a part of the wave guide 1. A stage 5, moveable to reciprocate in a direction perpendicular to the metallic mesh 6, is disposed inside the reaction chamber 10, and an object 11 to be processed is mounted on the stage 5, facing the metallic mesh 6. The microwave transmitting window 3, the metallic mesh 6 and the stage 5 are disposed approximately parallel to each other. The distance between the microwave transmitting window 3 and the metallic mesh 6 is desirably from 3 mm to 5 mm, and that between the metallic mesh 6 and the stage 5 desirably ranges from 5 mm to 20 mm. The latter distance is selected having regard to the plasma ashing rate and the ease of setting an object in position on the stage 5. The microwave transmitting window should have an area or size large enough to cover the whole of an object to be treated in order to treat the object perfectly. Advantageously the dimensions of the object to be treated are smaller than those of the microwave transmitting window.

An example of a plasma ashing process employing the apparatus of the present invention will now be described with respect to stripping a photoresist layer of Novolak resin (product of Tokyo Ohka Ltd, type OFPR-800) from a semiconductor substrate. A microwave of 1.5 kW having a frequency of 2.45 GHz, is applied. As a plasma reactive gas, oxygen ($O_2$) gas is introduced into the plasma generation chamber 9, and evacuated to a gas pressure ranging from 0.067 to 2.66 x $10^2$ Pa (0.05 to 2 Torr). The process is carried out in a similar manner to that employing the prior art plasma processing apparatus illustrated in Fig. 1.

Under the above conditions, the distribution of the plasma density in the plasma generation chamber is fairly uniform, so that uniformly distributed oxygen radicals are generated in the plasma and impinge on to the photoresist layer which covers the semiconductor substrate. Thus a fairly uniform ashing of the photoresist layer is realized, resulting in a great improvement in the ashing process: the selectivity of the plasma processing, namely the ratio of the etching rate of the photoresist film to that of silicon (Si) or that of silicon dioxide ($SiO_2$), is almost infinite, whereas when the prior art plasma processing apparatus of Fig. 1, is employed this ratio is approximately 200. The ashing rate is increased to 0.2 $\mu$m/min (2000 Å/min.) when the distance between the metallic mesh 6 and the stage 5 is 20 mm, and to 0.6 $\mu$m/min (6000 Å/min.) for a distance of 5 mm. In comparison the rate with the prior art apparatus is approximately 0.01 $\mu$m/min (100 Å/min.). The above results are obtained using a gas pressure of 0.67 x $10^2$ Pa (0.5 Torr).

As described above, by employing a plasma processing apparatus according to the present invention, short life-time radicals such as oxygen radicals can be used in an ashing process for stripping photoresist films from a substrate, providing a favourable result of uniform ashing and of a high ashing rate. Further, matching of the relevant microwave circuit becomes much more stable and easy compared with the prior art one.

## Claims

1. A downstream microwave plasma processing apparatus for treating a semiconductor substrate (11), employing microwave and reactive gas, said apparatus comprising:

   a microwave power source (12);

   a wave guide (1) for transmitting microwaves generated in said microwave power source;

   a microwave transmitting window (3) disposed in a wall of said wave guide, disposed perpendicular to an electric field of said microwaves in said wave guide;

   a vacuum processing vessel (4), a portion of which is defined by said microwave transmitting window;

a shielding member (6) having a plurality of openings, separating the inside space of said processing vessel into a plasma generation chamber (9) and a reaction chamber (10), said plasma generation chamber being defined by said microwave transmitting window and said shielding member; and

a stage (5) disposed in said reaction chamber facing said shielding means, for mounting said substrate.

2. A plasma processing apparatus according to claim 1, wherein said shielding member (6) is a metallic mesh.

3. A plasma processing apparatus according to claim 1, wherein said shielding member (6) is made from a perforated metal foil.

4. A plasma processing apparatus according to any preceding claim, wherein said reaction chamber (10) spatially adjoins said plasma generation chamber (9) through said shielding member (6).

5. A plasma processing apparatus according to any preceding claim, wherein the material of said microwave transmitting window (3) is a dielectric material.

6. A plasma processing apparatus according to claim 5, wherein said dielectric material is silica.

7. A plasma processing apparatus according to claim 5, wherein said dielectric material is ceramic.

8. A plasma processing apparatus according to any preceding claim, wherein said reactive gas comprises oxygen ($O_2$).

9. A plasma processing apparatus according to any preceding claim, wherein said stage is moveable to reciprocate in a direction perpendicular to said shielding member.

10. A plasma processing apparatus according to any preceding claim, wherein dimensions of an object to be processed are smaller than those of said microwave transmitting window.

11. A plasma processing apparatus according to any preceding claim, wherein said plasma generation chamber has a gas inlet (8) for introducing said reactive gas therein.

12. A plasma processing apparatus according to any preceding claim, wherein said processing vessel has an exhaust outlet (7) in a part other than said plasma generation chamber, for evacuating said processing vessel therethrough.

## Patentansprüche

1. Vorrichtung zum unterstromigen oder stromabwärtigen Bearbeiten mit mikrowellenerzeugtem Plasma, zum Behandeln eines Halbleitersubstrates (11) unter Anwendung von Mikrowellen und eines reaktiven Gases, welche Vorrichtung umfaßt:

eine Mikrowellenquelle (12);

einen Wellenleiter (1) zum Weiterleiten der in der Mikrowellenquelle erzeugten Mikrowellen;

ein für Mikrowellen durchlässiges Fenster (3), welches in der Wand des Wellenleiters angeordnet ist und senkrecht auf einem elektrischen Feld der Mikrowellen im Mikrowellenleiter steht;

ein Gefäß (4) zum Bearbeiten im Vakuum, von dem ein Teil durch das mikrowellendurchlässige Fenster definiert wird;

ein Schildelement (6) mit einer Mehrzahl von Öffnungen, welches den Innenraum des Bearbeitungsgefäßes in eine Plasmaerzeugungskammer (9) und in eine Reaktionskammer (10) trennt, welche Plasmaerzeugungskammer durch das mikrowellendurchlässige Fenster und durch das Schildelement definiert wird; und

eine in der Reaktionskammer angeordnete Bühne (5), welcher zum Schildelement gerichtet ist, zum Anbringen des Substrats.

2. Vorrichtung zum Bearbeiten mit Plasma nach Anspruch 1, worin das Schildelement (6) ein Metallgitter ist.

3. Vorrichtung zum Bearbeiten mit Plasma nach Anspruch 1, worin das Schildelement (6) aus einer durchlöcherten Metallfolie gemacht ist.

4. Vorrichtung zum Bearbeiten mit Plasma nach irgendeinem vorhergehenen Anspruch, worin die Reaktionskammer (10) räumlich an die Plasmaerzeugungskammer (9) über das Schildelement (6) angrenzt.

5. Vorrichtung zum Bearbeiten mit Plasma nach irgendeinem vorhergehenden Anspruch, worin das Material des mikrowellendurchlässigen Fensters (3) ein dielektrisches Material ist.

**6.** Vorrichtung zum Bearbeiten mit Plasma nach Anspruch 5, worin das dielektrische Material Silika ist.

**7.** Vorrichtung zum Bearbeiten mit Plasma nach Anspruch 5, worin das dielektrische Material aus Keramik ist.

**8.** Vorrichtung zum Bearbeiten mit Plasma nach irgendeinem vorhergehenden Anspruch, worin das reaktive Gas Sauerstoff ($O_2$) umfaßt.

**9.** Vorrichtung zum Bearbeiten mit Plasma nach irgendeinem vorhergehenden Anspruch, worin die Bühne beweglich ist, um sie in einer Richtung senkrecht auf das Schildelement hin und her zu bewegen.

**10.** Vorrichtung zum Bearbeiten mit Plasma nach irgendeinem vorhergehenden Anspruch, worin die Maße eines zu bearbeitenden Gegenstandes kleiner sind als jene des mikrowellendurchlässigen Fensters.

**11.** Vorrichtung zum Bearbeiten mit Plasma nach irgendeinem vorhergehenden Anspruch, worin die Plasmaerzeugungskammer einen Gaseinlaß (8) zum Einbringen des reaktiven Gases besitzt.

**12.** Vorrichtung zum Bearbeiten mit Plasma nach irgendeinem vorhergehenden Anspruch, worin das Bearbeitungsgefäß einen Anzugsauslaß (7) in einem anderen Teil als die Plasmaerzeugungskammer besitzt, zum Evakuieren des Bearbeitungsgefäßes.

**Revendications**

**1.** Appareil de traitement par plasma micro-onde en aval pour traiter un substrat semi-conducteur (11), utilisant une micro-onde et un gaz réactif, ledit appareil comprenant :
une source de micro-onde (12) ;
un guide d'ondes (1) pour transmettre les micro-ondes produites dans ladite source de micro-onde ;
une fenêtre de transmission de micro-onde (3) disposée dans une paroi dudit guide d'ondes, placée perpendiculairement à un champ électrique desdites micro-ondes dans ledit guide d'ondes ;
un récipient de traitement sous-vide (4), dont une partie est définie par ladite fenêtre de transmission de micro-onde ;
un élément formant écran (6) comportant un grand nombre d'ouvertures, séparant l'espace intérieur dudit récipient de traitement en une chambre de production de plasma (9) et une chambre de réaction (10), ladite chambre de production de plasma étant définie par ladite fenêtre de transmission de micro-onde et ledit élément formant écran ; et,
un support (5) disposé dans ladite chambre de réaction en face dudit moyen formant écran, pour supporter ledit substrat.

**2.** Appareil de traitement par plasma selon la revendication 1, dans lequel ledit élément formant écran (6) est un treillis métallique.

**3.** Appareil de traitement par plasma selon la revendication 1, dans lequel ledit élément formant écran (6) est fait d'une feuille de métal perforée.

**4.** Appareil de traitement par plasma selon l'une quelconque des revendications précédentes, dans lequel ladite chambre de réaction (10) est reliée spatialement à ladite chambre de production de plasma (9) par l'intermédiaire dudit élément formant écran (6).

**5.** Appareil de traitement par plasma selon l'une quelconque des revendications précédentes, dans lequel le matériau de ladite fenêtre de transmission de micro-onde (3) est un matériau diélectrique.

**6.** Appareil de traitement par plasma selon la revendication 5, dans lequel ledit matériau diélectrique est de la silice.

**7.** Appareil de traitement par plasma selon la revendication 5, dans lequel ledit matériau diélectrique est de la céramique.

**8.** Appareil de traitement par plasma selon l'une quelconque des revendications précédentes, dans lequel ledit gaz réactif comprend de l'oxygène ($O_2$).

**9.** Appareil de traitement par plasma selon l'une quelconque des revendications précédentes, dans lequel ledit support est mobile pour effectuer un mouvement de va et vient dans une direction perpendiculaire audit élément formant écran.

**10.** Appareil de traitement par plasma selon l'une quelconque des revendications précédentes, dans lequel les dimensions d'un objet à traiter sont plus petites que celles de ladite fenêtre de transmission de micro-onde.

**11.** Appareil de traitement par plasma selon l'une quelconque des revendications précédentes, dans lequel ladite chambre de production de plasma possède une entrée de gaz (8) pour y introduire ledit gaz réactif.

12. Appareil de traitement par plasma selon l'une quelconque des revendications précédentes, dans lequel ledit récipient de traitement possède une sortie d'évacuation (7) dans une partie autre que ladite chambre de production de plasma, pour mettre sous-vide, par celle-ci, ledit récipient de traitement.

## FIG. 1
### PRIOR ART

## FIG. 2